# EUROPÄISCHE PATENTANMELDUNG

(11) **EP 2 960 945 A2**
(43) Veröffentlichungstag der Anmeldung: **30.12.2015**
(21) Anmeldenummer: 14020083.3
(22) Anmeldetag: 12.11.2014
(51) Int. Cl.: H01L 31/02, H02H 7/20, H01H 9/54, H02H 7/22, H02H 3/16, H02H 3/33, H02J 3/38, H02H 3/087

(54) **Mit einem zentralen Wechselrichter verbundener Generator-Anschlusskasten zum lichtbogenfreien Schalten von PV-Modulen**

(30) Priorität: 12.11.2013 DE 102013018950
(71) Anmelder: Naebauer, Anton, 80805 München (DE)
(72) Erfinder: Naebauer, Anton, 80805 München (DE)

(57) **Zusammenfassung**

Sicherheitssystem für PV-Kraftwerke, das kostengünstig herstellbar ist, und bei dem die DC-Seite eines PV-Kraftwerks in kleinere Modulgruppen eingeteilt wird, innerhalb derer gefährliche Fehlerströme detektiert werden und sofern die Fehlerströme einen bestimmten Schwellwert überschreiten die betreffende Modulgruppe vom Gesamtsystem abgetrennt wird mit Hilfe eines Sicherheits-Trennschalters, der ein schnelles Abschalten einschließlich des Verlöschens des dabei entstehenden Lichtbogens gewährleistet.

## Beschreibung

Große PV-Kraftwerke stellen auch bezüglich der elektrischen Sicherheit ein gewisses Risiko dar. Dies ist unter anderem auch einer der Gründe warum PV-Kraftwerke in der Freifläche eingezäunt sind und die Anlagen in der Regel nur von unterwiesenen Fachleuten betreten und gewartet werden dürfen. Im Normalbetrieb sollten für Personen aber auch für Tiere (z. B. Schafe zur Beweidung der Fläche) keine Strom führenden Teile berührbar sein. Trotzdem kann es vorkommen dass zum Beispiel aufgrund eines Fehlers (z. B. defekte Isolation) oder auch im Rahmen von Wartungsaufgaben stromführende Teile unwissend oder versehentlich berührt werden. Dies kann für Mensch und Tier tödlich sein oder aber gesundheitliche Schäden verursachen. Grundsätzlich wird angestrebt, dass möglichst viele Wartungsaufgaben von ungelernten Arbeitern ausgeführt werden und sogar Tiere die Grünflächen beweiden können. So kann eine Beweidung mit Schafen das Mähen des Feldes weitgehend ersetzen. Aus diesem Grund ist es anzustreben, dass ein PV-Kraftwerk auch dann keine Gefahr darstellt, wenn ein stromführender Leiter berührt wird. Im Folgenden werden potentielle Gefahren durch die Berührung von Strom führenden Teilen im DC-Bereich eines PV-Kraftwerks aufgezeigt.

### 1. DC-Stromkreis mit den Modulen ist geerdet

Wenn die Module DC-seitig geerdet sind (z. B. negative oder positive Erdung nach Vorschrift des Modul-Herstellers), und ein Mensch einen unter gefährlicher Spannung stehenden Leiter berührt, kann der Strom durch den menschlichen Körper fließen mit den bekannten Gefahren und Folgen für die Gesundheit.

### 2. DC-Stromkreis ist nicht geerdet aber der Wechselrichter hat keine Potentialtrennung

Bezüglich der elektrischen Risiken gilt im Wesentlichen das Gleiche wie bei 1.

### 3. DC-Stromkreis mit den Modulen ist nicht geerdet und Wechselrichter hat eine Potentialtrennung

In diesem Fall ist die Gefahr wesentlich geringer als in den vorher dargelegten Fällen, solange keine Isolationsfehler vorliegen und der Isolationswiderstand innerhalb der erwarteten Werte liegt, was relativ einfach kontinuierlich überwacht werden kann. Trotzdem kann es auch hier, wenn alle Betriebsparameter eingehalten werden zu gefährlichen Situationen kommen, wenn unter gefährlicher Spannung stehende Teile berührt werden.

Solange keine Isolationsfehler vorliegen, können im Normalbetrieb keine statischen Ströme fließen, die eine wirkliche Gefahr darstellen würden. Unter bestimmten Randbedingungen kann es trotzdem zu gefährlichen Situationen kommen. Die Vorschrift für den Isolationswiderstand nach IEC-EN-DIN 61215 schreibt vor, dass der Isolationswiderstand der Module bezogen auf einen m² Modulfläche mindestens 40 MOhm beträgt. Nimmt man eine Installation mit einer Modulfläche von 4 000 m² (ca. 600 kWp bei typischen kristallinen Modulen) an und nimmt man an dass die Modulfläche mit einem leitfähigen Wasserfilm überzogen ist, oder mit Schnee bedeckt ist, dann kann theoretisch ein Isolationswiderstand von 40 MOhm/4000 = 10kOhm auftreten, sofern man annimmt dass der Schnee bzw. die feuchte Moduloberfläche einen gegenüber dem Glas relativ geringen Erdungswiderstand bildet. Geht man weiterhin von einer maximalen Systemspannung von 1000 V aus, können bei Berührung durch den Menschen bis zu 100 mA parasitäre Ströme auftreten, die eine große Gefahr darstellen!

Bei den üblicherweise angestellten Überlegungen zur Sicherheit werden in der Regel nur die statischen Ströme betrachtet und so gut wie nie die dynamischen Ströme. Eine Installation mit einer Modulfläche von 4 000 m² bei der das Glas 4 mm dick ist (E_{r-glas}= 6), und bei der die Modulfläche mit einem leitfähigen Wasserfilm überzogen ist oder von leitfähigem Schnee bedeckt ist, und der Schnee bzw. das Wasser einen Verbindung zu Erde herstellen, weist gegenüber Erde eine parasitäre Kapazität Cₚₛ = 4 000m²/4*10⁻³ m*6*8,85*10⁻¹²≈50µF.

Geht man davon aus, dass diese Kapazität auf die Systemspannung von 1000 V geladen ist, kann beim Entladen eine Energie von 0,5*50µF*(1000 V)² ≈ 25 J fließen. Dies ist ein Vielfaches von dem Schwellwert 350 mJ, der in den "Technischen Regeln zur Betriebssicherheit" TRBS 2131 für eine menschliche Gefährdung genannt wird. In den beschriebenen Beispiel kann die Ladung der Kapazität bis zu 50 µF*1000 V ≈ 50 mAs betragen.

Zum Vergleich: In IEC 62109-2:2011-06 ist vorgeschrieben dass bei einem Fehlerstrom von 150 mA ein Wechselrichter innerhalb von 40 ms abgeschaltet werden muss. Dabei kann eine Ladung von 150 mA*40 ms ≈ 6 mAs fließen.

An diesem Beispiel ist zu erkennen, dass unter den beschriebenen Bedingungen die dynamischen Ströme bei weitem gefährlicher sind als die statischen Ströme.

Um die elektrische Sicherheit von PV-Kleinanlagen (z. B. mit einer Leistung von 10 kWp), in deren Nähe sich Personen aufhalten, zu erhöhen, werden häufig FI-Schalter verwendet, die auf der Wechselstromseite des Wechselrichters angebracht sind.

Im Falle eines Fehlerstromes im System wird die gesamte Anlage vom Wechselstromnetz getrennt, so dass keine gefährlichen Ströme mehr über die Anlage zur Erde fließen können.

Diese Art der Absicherung ist prinzipiell auch bei großen PV-Kraftwerken möglich, wenn jeweils kleinere Modulgruppen (z. B. mit 20 kWp) einen eigenen Wechselrichter (und auch einen eigenen FI-Schalter) besitzen. Wenn aber PV-Module mit mehreren 100 kWp an einem Zentral Wechselrichter angeschlossen sind, ist es schwierig einen Schalter aufzubauen, der bei Strömen von über 100 A Fehlerströme im der Größenordnung von 10 mA detektieren kann und innerhalb weniger ms das gesamte System vom Netz trennen kann.

Grundsätzlich sind FI-Schalter für Wechselstrom (AC) leichter realisierbar als für Gleichstrom (DC), da
- das Messen von Wechselstrom Differenzströmen mit Hilfe der von den Strömen erzeugten Magnetfelder bei AC einfacher ist als bei DC,
- DC-Schalter wegen der potentiellen Gefahr der Entstehung von nicht automatisch verlöschenden Lichtbögen deutlich aufwändiger sind als AC-Schalter (beim Nulldurchgang des Stromes verlöscht der Lichtbogen von selbst).

Die elektrische Personen-Sicherheit von PV-Kraftwerken mit Zentralwechselrichtern mit mehreren 100 kWp kann deutlich gesteigert werden, wenn der DC-Teil in mehrere Modulgruppen eingeteilt wird, von denen jede so klein ist, dass auch unter ungünstigen Betriebsbedingungen (z. B. Schnee auf Modul) sowohl die statischen Leckströme, als auch die maximal vorstellbaren parasitären dynamischen Ströme bzw. die damit verbundene Energien so gering sind, dass eine Gefährdung von Mensch (und Tier) weitestgehend ausgeschlossen werden kann.

Der Erfindung liegt die Aufgabe zu Grunde, ein Sicherheitssystem für große PV-Kraftwerke zur Verfügung zu stellen, das kostengünstig herstellbar ist, und die Gefährdung von großen PV-Kraftwerken für Mensch und Tier deutlich reduziert. Diese Aufgabe wird erfindungsgemäß dadurch gelöst, dass der DC-Teil des PV-Kraftwerks in kleinere Modulgruppen eingeteilt wird, innerhalb derer gefährliche Fehlerströme detektiert werden und sofern die Fehlerströme einen bestimmten Schwellwert überschreiten die betreffende Modulgruppe vom Gesamtsystem abgetrennt wird mit Hilfe eines Sicherheits-Trennschalters, der ein schnelles Abschalten einschließlich des Verlöschens des dabei entstehenden Lichtbogens gewährleistet.

Für den Sicherheits-Trennschalter werden zwei alternative Realisierungen offengelegt.

Bei der ersten Alternative handelt es sich um einen (optional: auch manuell bedienbaren) Trennschalter (ähnlich wie übliche Sicherungsautomaten bzw. Leitungsschutzschalter bzw. Miniatur Circuit Breaker (MCB)) der mit Hilfe eines sogenannten "Shunt Trip" ein schnelles (innerhalb weniger ms) Abschalten gewährleistet und der weiterhin durch Ergänzung mit einem Wiedereinschaltgerät ("Recloser") innerhalb weniger Sekunden wieder eingeschaltet werden kann. Der Trennschalter und die zugeordneten Zusatzeinrichtungen (Shunt trip, Recloser, Hilfsschalter mit dem der Schaltzustand des Trennschalters ausgelesen werden kann) wird im Folgenden als "MCB plus"

### (Miniatur Circuit Breaker plus Zusatzeinrichtungen)

Bei der zweiten Alternative wird der Trennschalter realisiert durch einen Relais, dem ein elektronisches Schalternetzwerk (Lichtbogenunterdrückungsnetzwerk) parallel geschaltet ist, das verhindert, dass es zu einem dauerhaften Lichtbogen im Relais kommt.

In verschiedenen Weiterbildungen der Erfindungen wird das System durch folgende Eigenschaften erweitert:
- System zur ferngesteuerten Fehlersuche und Systemdiagnose
- Alarmsystem, das Moduldiebstahl erkennt und erschweren soll
- System, das Rückströme in angeschlossenen Modulgruppen erkennt und verhindert
- System, das in der Nacht eine Modulregeneration gegen Potential Induzierte Degradation (PID) ermöglicht.

Wie oben beschrieben besteht bei Gleichstrom (DC) besonders die Gefahr, dass ein Lichtbogen entsteht, der nicht verlöscht. Aus diesem Grund sind Relais, die DC schalten bei Schaltspannungen von mehreren 100 V und darüber deutlich teurer als Relais für AC (Wechselstrom) bei gleicher Schaltleistung. Relais für Gleichstrom können deutlich günstiger gebaut werden, wenn dafür Sorge getragen wird, dass beim Öffnen des stromdurchflossenen Relais kein Lichtbogen entsteht, bzw. der Lichtbogen sogleich gelöscht wird. Die geschieht erfindungsgemäß durch ein elektronisches Schalternetzwerk das parallel geschaltet wird. Dieses Netzwerk ist in einem einfachen erfindungsgemäßen Fall ein elektronischer Schalter, der hier auch als Bypass-Schalter bezeichnet wird.

Beispielhaft sollen die Anforderungen an die schaltenden Elemente dargestellt werden für einen PV-Stromkreis mit 1000 V Systemspannung und einem maximalen Strom von 20 A.

Geht man davon aus, dass das Relais nach dem Beginn des Ausschaltvorgange eine 10 ms lange Kontaktprellphase hat, dann muss ein parallel geschaltetes Netzwerk, das den Lichtbogen unterdrückt 10 ms lang den wesentlichen Strom aufnehmen. In der darauffolgenden Phase sollte dann das Lichtbogenunterdrückungsnetzwerk (Bypass-Schalter) beispielsweise innerhalb 0,1 ms ausschalten.

Die Leistungen und Energien, die vom Lichtbogenunterdrückungsnetzwerk aufgenommen werden sind:

Innerhalb der Kontaktprellphase bei einem Spannungsabfall über dem Bypass von 5 V ergeben sich: 20 A * 5 V = 100 W; woraus sich dann mit der Zeitdauer von 10 ms eine Energie von 1 Ws berechnen lässt.

In der darauf folgenden Abschaltphase des elektronischen Schalternetzwerks steigt die Leistung an, da der Spannungsabfall über dem Lichtbogenunterdrückungsnetzwerk ansteigt. Es wird davon ausgegangen, dass in dieser Phase die Verlustleistung des Schalters kurzzeitig auf bis zu 500 V * 10 A = 5 000 W ansteigen kann. Mit Hilfe der Annahme, dass das Abschalten sehr schnell erfolgt (innerhalb von 0,1 ms) kann man die in dieser Phase zu verbrauchende Energie im Beispiel mit 0,5 Ws abschätzen.

Für den Schaltvorgang muss das Lichtbogenunterdrückungsnetzwerk also eine Energie von 1,5 Ws aufnehmen. Da dies nur selten (nach Pausen von mehreren Sekunden) vorkommt kann die kurzzeitig in Wärme umgewandelte Energie leicht über einen längeren Zeitraum abgeführt werden, und das elektronische Schalternetzwerk im muss nicht besonders gekühlt werden.

Mit heutigen Leistungs IGBTs, die geschickt angesteuert werden, lässt sich ein Bypass-Schalter zum Unterdrücken des Funkens herstellen. Diese Transistoren erreichen kurze Abschaltzeiten (< 1 ms) bei einem Leckstrom von unter 1 mA (der keine Gefahr mehr darstellt) und haben ausreichend thermische Trägheit, dass die oben abgeschätzten Energiemengen kurzfristig aufgenommen werden können. Darüber hinaus sind die dafür erforderlichen Halbleiter preiswert verfügbar.

Im Folgenden wird angenommen dass das Schalternetzwerk ein einfacher Bypass-Schalter ist. Beim Einschalten des PV-Stromkreises wird gleichzeitig der Bypass-Schalter und der Relais eingeschaltet. Da der elektronische Schalter (z. B. IGBT) schneller einschaltet, fließt der Strom zunächst nur über den Bypass-Schalter im Bypass und dann während der Kontaktprellphase komplementär ergänzend zusätzlich durch den Relais und schließlich so gut wie nur noch durch den besser leitenden eingeschalteten Relais.

Soll der PV-Stromkreis abgetrennt werden, wird zunächst der mechanische Schalter so angesteuert, dass der Stromkreis zunächst mit der Kontaktprellphase geöffnet wird. Der parallele elektronische Bypass-Schalter öffnet erst mit einer Verzögerung, wobei die Verzögerungszeit so bemessen ist, dass die Kontaktprellphase vor dem Öffnen des elektronischen Bypass-Schalters sicher abgeschlossen ist. Erst dann wird der elektronischen Schalter abgeschaltet.

Grundsätzlich ist anzustreben, dass die Kontaktprellphase möglichst kurz ist, da es ja das Ziel ist, den DC PV-Stromkreis im Fehlerfall so schnell wie möglich vom übrigen System abzutrennen, um gefährliche parasitäre Ströme zu vermeiden.

In einer Weiterbildung der Erfindung wird ein Generatoranschlusskasten (GAK) dahingehend optimiert, dass er die beschriebenen Sicherheitsfunktionen für eine Vielzahl von Modulgruppen (eine Modulgruppe ist im einfachsten Fall ein Modulstring) übernimmt und zusätzlich Funktionen übernimmt, die unter anderem auch helfen die Verkabelungskosten des PV-Systems zu reduzieren. Die Kostenreduktion bei der Verkabelung der Strings wird dadurch erreicht, dass statt den üblichen Schmelzsicherungen, die im GAK als Sicherung zum Schutz vor Rückströmen im Modul eingebaut sind, eine nachfolgend beschriebene elektronische Schutzschaltung eingebaut wird. Hierdurch wird ermöglichst, dass die Verkabelung zu den Modulstrings in einigen Bereichen der Anlage zusammengefasst werden kann, und dadurch Kosten gespart werden.

Angenommen in einem System kann ein String einen maximalen Strom von 10 A liefern und einen maximalen Rückstrom von 15 A aufnehmen, dann wird beispielsweise jede einzelne Stringleitung im System mit 15 A abgesichert. Würde man 2 Strings parallel schalten und gemeinsam mit 30 A absichern, kann es vorkommen, dass der erste String einen Strom von 10 A erzeugt und der zweite String verschattet ist. Im worst case könnte dann in den zweiten parallel geschalteten (verschatteten!) String über die Sicherung ein Rückstrom von 30 A dazukommen, was dann in Summe 40 A Rückstrom wären, die den zweiten String durchfließen könnten und damit den maximalen spezifizierten Rückstrom deutlich übertreffen.

Würde man, was häufig gemacht wird, statt der String-Sicherungen, oder in Serie mit einer der Stringsicherung eine Diode (PV Blocking Diode) einbauen (die im Normalbetrieb in Flusspolung geschaltet ist), dann könnte über die Diode kein Rückstrom zu den Strings fließen.

Daher ist es möglich zwei Strings parallel zu schalten und gemeinsam abzusichern. Wenn nun nur einer der Strings Strom erzeugt, kann in den zweiten (verschatteten) String maximal der im ersten String erzeugte Strom als Rückstrom fließen.

Die Ersparnis, die hiermit erzielt werden kann, liegt nicht nur in der potentiellen Ersparnis von Sicherungen, sondern auch bei der Möglichkeit zwei Strings mit einer gemeinsamen Leitung an den GAK anzuschließen, wodurch die Verkabelungskosten für die Strings deutlich reduziert werden können.

Die Verwendung einer "Blocking Diode" ist leider mit zusätzlichen elektrischen Verlusten verbunden in der Größenordnung von 0,1 %.

Da für das oben beschriebene Sicherheitssystem elektronische Trennschalter benötigt werden, die eine Gruppe von Strings vom System trennen können, ist es besonders vorteilhaft, mit diesen Trennschaltern auch die Funktionen der Stringsicherungen (Schutz der Stringleitungen und Schutz vor Modulrückströmen) zu realisieren. Dazu ist es erforderlich im Generatoranschlusskasten die Ströme einer Gruppe von Modulen zu erfassen und bei Überstrom als auch bei Rückströmen die entsprechende Gruppe mit Hilfe des Lasttrennschalters abzutrennen.

Damit ist es möglich, eine Gruppe von beispielsweise 2 Strings im Generatorfeld zusammenzufassen und gemeinsam zum Generatoranschlusskasten zu führen (und damit Leitungskosten einzusparen). Im Generatoranschlusskasten können dann die für jeden String erforderlichen Rückstromsicherungen entfallen. Unter Umständen ist es jedoch sinnvoll die Modulgruppe mit mehreren String durch eine höher dimensionierte Schmelzsicherung gegen Kabelschäden abzusichern.

In einer Weiterbildung der Erfindung können die für die Sicherheitselektronik eingebauten Trennschalter dazu verwendet werden, dass auch im Normalbetrieb des PV-Kraftwerks ferngesteuert Strings oder Gruppen von Strings abgetrennt werden und gegebenenfalls durch zusätzliche Messeinrichtungen vermessen (z. B. Isolationswiederstand zu Erde, Leckströme zu Erde, Kennlinie einer Modulgruppe, Leerlaufspannung einer Modulgruppe, Kurzschlussstrom einer Modulgruppe) werden. Hierdurch wird eine weitegehend ferngesteuert durchgeführte Systemdiagnose und Fehlersuche möglich, bei der die Fehler sehr eng eingekreist werden können. Je nach gefundenem Fehler ist es dann möglich, eine einzelne Modulgruppe bis zu einer später geplanten Reparatur abzuschalten oder auch Modulgruppen wieder zuzuschalten. Die Diagnosemöglichkeiten können auch noch so weit ausgebaut werden, dass (auch nachts) bei einzelnen Strings Unterbrechungen (wie sie bei einem Diebstahl zwingend auftreten) oder Änderungen der Impedanz detektiert werden und schließlich Alarm ausgelöst wird. Um auch nachts die Funktion der Diagnosemöglichkeiten und insbesondere des Alarmsystems zu gewährleisten sollte eine Stromversorgungseinrichtung vorhanden sein, die auch nachts die Versorgung der wichtigsten Funktionen gewährleistet. Dies kann dadurch erfolgen, dass die geringe Energie, die die angeschlossenen Solarmodul auch nachts erzeugen dafür verwendet wird, oder, dass vom angeschlossenen Zentral-Wechselrichter (oder der zentralen Datenverarbeitungszentrale) her Energie geliefert wird, oder aber, dass ein Akku eingebaut wird, der unter Tag aufgeladen wir und Nachts die Energieversorgung des der beschriebenen Systemteile sichert. Es wurde gefunden, dass eine Rückspeisung über den Wechselrichter besonders kosteneffektiv ist, da keine zusätzlichen Leitungen erforderlich sind. Hierzu ist es zweckmäßig, dass im Generatoranschlusskasten ein DC-DC Wandler mit besonders großem Eingangsspannungsbereich vorhanden ist, der sowohl vom Wechselrichter als auch von den angeschlossenen PV-Modulen gespeist werden kann. Der Eingangsspannungsbereich sollte von unter 100V beginnend (z. B. 12 V) bis zur Systemspannung (üblicherweise bis zu 1000V oder bis zu 1500 V) gehen. Damit ist es möglich, nachts einfach über einen Akku die Energieversorgung zu gewährleisten, während bei hoher Einstrahlung die Systeme direkt von den PV-Modulen versorgt werden.

Sollten Betriebsbedingungen vorliegen, die eine Potentialinduzierte Degradation (PID) der Module befürchten lassen, ist es zweckmäßig in der Nacht an die Module Spannungen anzulegen, die der PID entgegenwirken und den PID-Schaden ganz oder teilweise wieder heilen können. Die dafür erforderlichen Spannungen sind abhängig vom in den Modulen verwendeten Zelltyp. In den meisten Fällen wirkt eine hohe positive Spannung der PID entgegen.

Zusammenfassend kann man sagen, dass durch die für die Sicherheitsfunktionen erforderlichen Trennschalter, mit denen einzelne Strings oder Gruppen von Strings abgetrennt werden können, neben der erhöhten elektrischen Sicherheit weitere Potentiale zur Kosteneinsparung auf Systemebene erschlossen werden. Diese sind beispielsweise:
- Beweidung der Anlage durch Tiere
- Doppelernte (Nutzung der Fläche auch für Landwirtschaft bei geringster elektrischer Gefährdung)
- ferngesteuerte Fehlersuche und Systemdiagnose
- Erschweren von Moduldiebstahl durch Alarmsystem
- Modulregeneration gegen PID Schäden

In einer Weiterbildung der Erfindung kann der Generatoranschlusskasten noch ergänzt werden durch einen oder mehrere MPP-Tracker, die jeweils einer Modulgruppe oder mehreren Modulgruppen zugeordnet sind und die für die zugeordneten Strings den optimalen Arbeitspunkt einstellen. Damit ist es möglich, dass innerhalb eines PV-Kraftwerkes Module verschiedener Leistungsklassen verwendet werden, sofern diese dann an unterschiedlichen MPP-Trackern angeschlossen sind, oder dass innerhalb des Kraftwerks (jedoch nicht innerhalb einer Modulgruppe) die Zahl der Module, die in einem String seriell verschaltet sind variiert. Damit wird es einfacher die Strings bei schwierigen Geländeformen auf dem Gelände zu verschalten.

Im Folgenden wird die Erfindung beispielhaft anhand der beiliegenden Figuren erläutert. Es zeigen:
- Fig. 1:: Beispielhafter Aufbau eines PV-Kraftwerks
- Fig. 2:: Ausschnitt des DC-Teil eines PV-Kraftwerks mit zwei Modulgruppen und Generatoranschlusskasten
- Fig. 3:: Beispielhafter Aufbau eines erfindungsgemäßen Generatoranschlusskastens wobei nur für eine Modulgruppe die ausführliche Schaltung gezeigt ist.
- Fig. 4:: links oben: Ausschnitt von Schaltbild von Fig. 3; rechts oben: Aufbau der den Trennschaltern zugeordneten Zusatzeinrichtungen; unten: Realisierung durch modulare Hutschienen Installations Elemente.
- Fig. 5:: Beispielhafter Aufbau eines erfindungsgemäßen Generatoranschlusskastens mit Relais als Trennschalter wobei nur für eine Modulgruppe die ausführliche Schaltung gezeigt ist.
- Fig. 6:: Schaltung für bidirektionalen Bypass-schalter mit zwei IGBTs
- Fig. 7:: Schaltung für bidirektionalen Bypass-schalter mit Brückengleichrichter
- Fig. 8:: Schaltung bei der dem Relais eine Serienschaltung von Bypass-Schalter und Transientenschalter parallel geschaltet ist.

### Bezugszeichenliste:

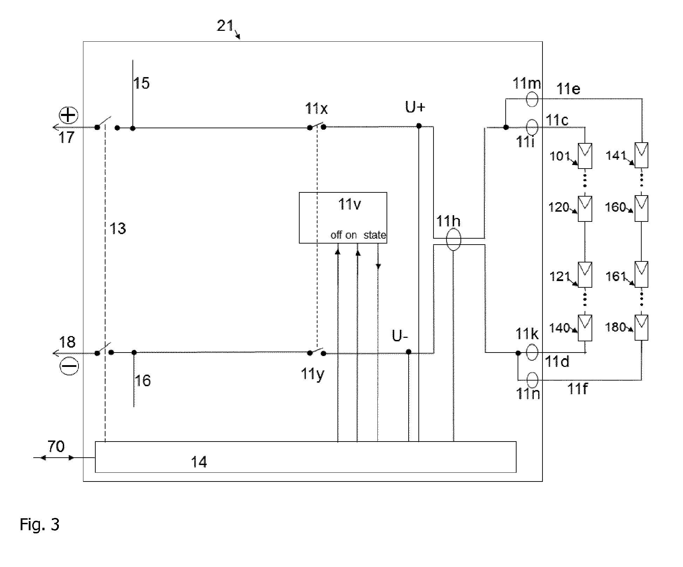

- 11a: Sicherungen für Pluspol der ersten Modulgruppe 100
- 11b: Sicherungen für Minuspol der ersten Modulgruppe 100
- 11c: Leitung für Plus von der ersten Modulgruppe und String mit Modul 101 .. 140 zum GAK
- 11d: Leitung für Minus von der ersten Modulgruppe und String mit Modul 101 ... 140 zum GAK
- 11e: Leitung für Plus von der ersten Modulgruppe und String mit Modul 141 .. 180 zum GAK
- 11f: Leitung für Minus von der ersten Modulgruppe und String mit Modul 141 ... 180 zum GAK
- 11g: Diode zur Verhinderung von Rückströmen bei Modulgruppe 100 ("Blocking Diode")
- 11h: Differenzstrommessung zum Detektieren von Fehlerströmen in der ersten Modulgruppe
- 11i: Strommessung für Plusspol der ersten Modulgruppe 100 (Fig. 3: Teilbereich 101 ... 140)
- 11k: Strommessung für Minuspol der ersten Modulgruppe 100 (Fig. 3: Teilbereich 101 ... 140)
- 11m: Strommessung für Plusspol der ersten Modulgruppe 100 (Fig. 3: Teilbereich 141 ... 180)
- 11n: Strommessung für Minuspol der ersten Modulgruppe 100 (Fig. 3: Teilbereich 141 ... 180)
- 11p: elektronischer Bypass-schalter gesteuert von 14 für 11t
- 11q: elektronischer Bypass-schalter gesteuert von 14 für 11u
- 11r: Plus-Anschluss der Komponenten der ersten Modulgruppe an der Plus-Sammelschiene 15 des GAK
- 11s: Minus-Anschluss der Komponenten der ersten Modulgruppe an der Minus-Sammelschiene 16 des GAK
- 11t: Relais gesteuert von 14 für Plus-Strompfad der Modulgruppe 100
- 11u: Relais gesteuert von 14 für Minus-Strompfad der Modulgruppe 100
- 11v: Zusatzeinrichtungen für Trennschalter 11x, 11y
- 11x: Trennschalter für Plus
- 11y: Trennschalter für Minus
- 12a: Sicherungen für Pluspol der zweiten Modulgruppe 200
- 12b: Sicherungen für Minuspol der zweiten Modulgruppe 200
- 12g: Diode zur Verhinderung von Rückströmen bei Modulgruppe 200 ("Blocking Diode")
- 12i: Strommessung für Plusspol der ersten Modulgruppe 200
- 12k: Strommessung für Minuspol der ersten Modulgruppe 200
- 12r: Plus-Anschluss der Komponenten der zweiten Modulgruppe an der Plus-Sammelschiene des GAK
- 12s: Minus-Anschluss der Komponenten der zweiten Modulgruppe an der Minus-Sammelschiene des GAK
- 13: Hauptschalter für Generatoranschlusskasten
- 14: Messelektronik, Steuerelektronik des Generatoranschlusskastens sowie Daten-Kommunikationsinterface
- 15: Plus-Sammelschiene im Generatoranschlusskasten
- 15b: Bypass-Sammelschiene für Plus
- 16: Minus-Sammelschiene im Generatoranschlusskasten
- 17: Pluspol des Ausgangs von Generatoranschlusskasten zum Wechselrichter
- 18: Minuspol des Ausgangs von Generatoranschlusskasten zum Wechselrichter
- 19: elektronischer Schalter (Transientenschalter) zur Aufnahme der Energie beim Ein- und Ausschaltvorgang
- 21: erster Generator Anschlusskasten
- 50: Wechselrichtersystem (Wechselrichter mit ergänzenden Systemen)
- 51: Sicherungen im Wechselrichter für ersten Generatoranschlusskasten
- 51a: Sicherungen für Pluspol im Wechselrichter für ersten Generatoranschlusskasten
- 51b: Sicherungen für Minuspol im Wechselrichter für ersten Generatoranschlusskasten
- 52: Sicherungen im Wechselrichter für zweiten Generatoranschlusskasten
- 52a: Sicherungen für Pluspol im Wechselrichter für zweiten Generatoranschlusskasten
- 52b: Sicherungen für Minuspol im Wechselrichter für zweiten Generatoranschlusskasten
- 63: Steuerelektronik und Dateninterface des Wechselrichters für die Generatoranschlusskästen
- 64: MPPT -Schaltung (Maximum Power Point Tracker)
- 65: Wechselrichter ohne Zusatzsysteme
- 66: Transformator zur Potentialtrennung und zur Ankopplung an Netz sowie Schaltanlage
- 70: Datenleitung zwischen Wechselrichtersystem und Generatoranschlusskasten
- 80: Stromnetz
- 81: Shunt Trip (Initiieren des schnellen Ausschaltens) gemeinsam für 11x, 11y
- 82: Wiedereinschaltgerät gemeinsam für 11x, 11y
- 83: Hilfsschalter, der gemeinsamen Status von 11x, 11y erfasst
- 91: elektronischer Schalter (z. B. IGBT)
- 92: elektronischer Schalter (z. B. IGBT)
- 93: Potentialtrennung
- U+: Messpunkt für positive Stringspannung
- U-: Messpunkt für negative Stringspannung

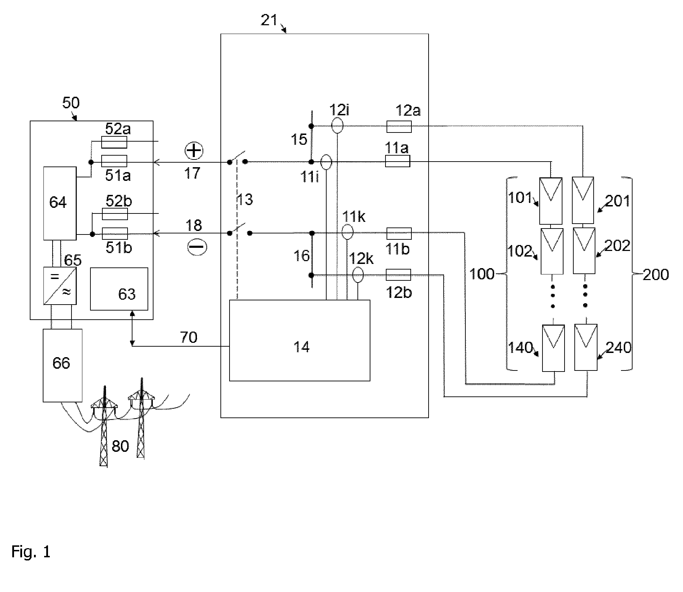

Figur 1 zeigt beispielhaft einen typischen Aufbau eines PV-Kraftwerks. Aus dem Sonnenlicht wird im String 100, der aus den Modulen 101 - 140 besteht und im String 200 der aus den Modulen 201 - 240 besteht Gleichstrom erzeugt. Dass hierbei ein String aus 40 Modulen besteht ist nur beispielhaft angenommen. Die Zahl der Module in einem String kann beliebig sein. Typische Werte sind 2 ... 100 Module. Ebenso sind in Figur 1 zwei Strings eingezeichnet, die am Generatoranschlusskasten angeschlossen sind. Typische Werte, für die Zahl der Strings an einem Generatoranschlusskasten sind 2 - 100 Strings. Für jeden String (100, 200, ...) ist im

Generatoranschlusskasten je eine Schmelzsicherung C11a, 12a) für den Pluspol und eine Sicherung (11b, 12b) für den Minuspol vorgesehen. Diese Sicherungen erfüllen im Wesentlichen zwei Funktionen. Die erste Funktion ist der Schutz der elektrischen Leitungen zwischen String (100, 200, ...) und Generatoranschlusskasten (aus diesem Grund benötigt man auch je eine Sicherung in der Plus- und in der Minus-Leitung). Die zweite Funktion ist der Schutz der Module vor Rückströmen. Nach der Spezifikation typischer kristalliner Module benötigt man bei Systemen mit Zentralwechselrichter für jeweils einen String eine eigene Rückstromsicherung.

Im Generatoranschlusskasten werden die Strings parallel geschaltet und über einen GAK-Hauptschalter 13 und die Leitungen 17, 18 an das Wechselrichtersystem geleitet.

Der GAK-Hauptschalter dient dazu, dass im PV-Kraftwerk beispielsweise für Servicezwecke größere Gruppen von Strings abgeschaltet werden. Über die Steuerelektronik 14 kann dieser Schalter unter Umständen ferngesteuert bedient werden, oder, wenn er nicht ferngesteuert wird, kann von der Steuerelektronik 14 die Schalterstellung abgefragt werden. Zusätzlich können in einem Generatoranschlusskasten Systeme zur Messung der Ströme der einzelnen Strings eingebaut werden. Diese sind für die Pluspole der Strings mit 11i, 12i, ... angedeutet und für die Minuspole der Strings mit 11k, 12k, angedeutet.

Im Wechselrichtersystem 50 durchläuft der Strom vom ersten Generatoranschlusskasten am Eingang zunächst wieder die Sicherungen 51a für den Pluspol und 51b für den Minuspol. Da an einem Wechselrichtersystem in der Regel mehrere Generatoranschlusskästen angeschlossen werden können, sind im Wechselrichtersystem die Sicherungen 52a, 52b für den zweiten Generatoranschlusskasten schon skizziert. Typischerweise sind an einem Wechselrichtersystem (Zentral-Wechselrichter) 2 ... 20 Generatoranschlusskästen angeschlossen.

Im Wechselrichtersystem befindet sich dann noch mindestens ein Maximum Power Point Tracker (MPPT) 64, an dessen Ausgang sich dann der eigentliche Wechselrichter 65 befindet. Dieser ist dann über einen Transformator und eine Schaltanlage 66 am Stromnetz 80 (z. B. Mittelspannungsnetz) angeschlossen. Zusätzlich kann sich im Wechselrichtersystem noch eine Steuerelektronik befinden und ein Dateninterface 63, das unter anderem die Kommunikation mit mehreren Generatoranschlusskästen übernehmen kann über die Datenleitung 70.

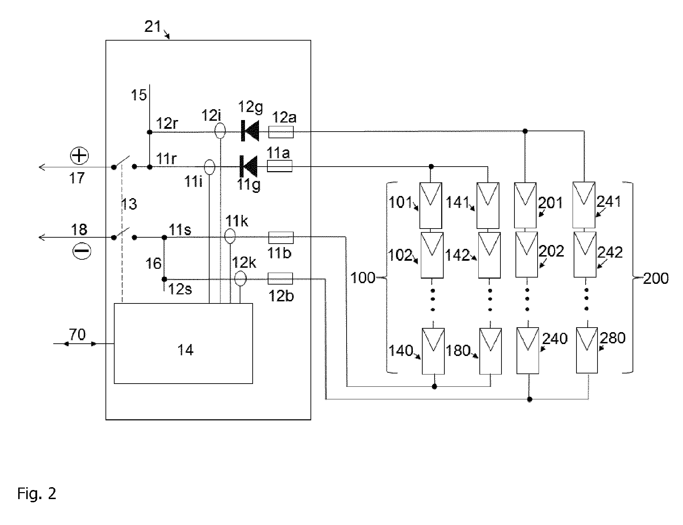

In Figur 2 ist ein wesentlicher Ausschnitt des DC-Teils eines PV-Kraftwerks mit Generatoranschlusskasten 21 und zwei Modulgruppen 100, 200 gezeichnet. Jede der beiden Gruppen besteht beispielhaft aus 2 parallel geschalteten Modulstrings. Der erste String der ersten (bzw. zweiten) Modulgruppe wird beispielhaft aus 40 Module (bezeichnet mit 101 - 140 (bzw. 201 - 240) gebildet, während der zweite String beispielhaft aus den Modulen 141 - 180 (bzw. 241 - 280) gebildet wird. Im Generatoranschlusskasten 21 ist beispielhaft zusätzlich auf der Plus-Seite seriell für jede Gruppe jeweils eine Diode 11g, 12g eingebaut. Diese Dioden erlauben auf der Plus-Seite nur einen Stromfluss von den Modulgruppen zum Generatoranschlusskasten (GAK) und nicht umgekehrt. Damit ist sichergestellt, dass wenn einer der beiden Strings verschattet ist, der maximale Rückstrom in diesem String durch den Strom gegeben ist, den der andere String erzeugt. An diesem Beispiel ist zu erkennen, dass der Einbau einer "Blocking Diode" im GAK als Vorteil bringt, dass mehrere Strings (in diesem Beispiel zwei Strings) zu einer Gruppe zusammengefasst werden können, und nicht mehr jeder String einzeln zum GAK geführt werden muss um diesen String gegen Rückströme abzusichern.

Weiterhin sind in Figur 2 Strommesseinrichtungen vorgesehen, mit deren Hilfe die Ströme im Strompfad für Plus (für Modulgruppe 100 gebildet aus Sicherung 11a, Diode 11g, Stromsensor 11i und endend mit dem Anschluss 11r an der Plus-Sammelschiene 15; für Modulgruppe 200 gebildet aus Sicherung 12a, Diode 12g, Stromsensor 12i und endend mit dem Anschluss 12r an der Plus-Sammelschiene 15) und die Ströme im Strompfad für Minus (für Modulgruppe 100 gebildet aus Sicherung 11b, Stromsensor 11k und endend mit dem Anschluss 11s an der Minus-Sammelschiene 16; für Modulgruppe 200 gebildet aus Sicherung 12b, Stromsensor 12k und endend mit dem Anschluss 12s an der Minus-Sammelschiene 16) gemessen werden können. Diese dienen der Systemüberwachung und dabei insbesondere der Leistungsmessung jeder einzelnen Modulgruppe. Für jede Modulgruppe sind zwei Stromsensoren eingezeichnet, wobei einer in den meisten Fällen redundant ist und auch wegfallen könnte.

Die Steuerelektronik 14 wertet alle Messgrößen (z. B. Ströme, Spannungen, Temperatur, Feuchtigkeit, ... ) aus und kommuniziert die ermittelten Informationen mit einen übergeordnetem System, das beispielsweise im Wechselrichter untergebracht ist. Die Steuerelektronik 14 ist nur einmal für den gesamten Generatoranschlusskasten erforderlich. Allerdings wird die Steuerelektronik 14 entsprechend umfangreicher, je mehr Kanäle (an jedem Kanal kann eine Modulgruppe angeschlossen werden) der Generatoranschlusskasten besitzt, da ja für jeden Kanal die Ströme gemessen werden müssen und für jeden Kanal die Schaltelemente eigens angesteuert werden müssen. Von der Steuerelektronik werden insbesondere Fehler und Gefahrenzustände (Fehlerströme) erkannt und bei Bedarf Modulgruppen getrennt.

In Figur 3 ist eine erste Realisierungsmöglichkeit für den erfindungsgemäßen Generatoranschlusskasten gezeigt. Der Strom der beiden parallel geschalteten Modulstrings fließ über eine Reihe von Stromsensoren in der Plus- und Minus-leitung über einen Differenzstrom -Sensor mit Hilfe dessen Fehlströme (Abweichungen des Betrags des Stroms in der Minus-Leitung und der Plus-Leitung) detektiert werden können zu den Trennschaltern 11x (für Plus) und 11y (für Minus).

Vor dem Trennschalter gibt es noch Messpunkte U+ und U- an denen die positive und die negative Stringspannung jeweils gegenüber Masse gemessen werden. Sollte die betrachtete Modulgruppe (hier mit 2 Strings) durch den Trennschalter vom übrigen System abgetrennt sein, können durch diese Potentialmessungen Informationen gewonnen werden, ob die Module richtig gepolt angeschlossen sind (dies ist wichtig bei der Installation der Anlage), wie hoch die Leerlaufspannung der Module ist, ob Rückströme zu erwarten sind, oder falls relevante Leckströme detektiert wurden, an welcher Stelle im String (bei welchem Modul) wahrscheinlich ein Erdschluss besteht. Die beiden Trennschalter werden im Fehlerfall (Überstrom, Plötzlicher Fehlerstrom (hoher Differenzstrom), plötzliche Änderung des Differenzstroms, ...) gesteuert von der Steuerelektronik 14 (die alle Messsignale auswertet) gemeinsam sehr schnell ausgeschaltet durch den Shunt Trip 81. Bei Bedarf (z. B. nachdem verschiedene Diagnoseroutinen abgelaufen sind) können die beiden Trennschalter 11x, 11y durch ein gemeinsames Wiedereinschaltgerät 82 (gesteuert von 14) wieder eingeschaltet werden, so dass die betrachtete Modulgruppe jetzt mit den Sammelschienen im GAK verbunden sind, und bei eingeschaltetem GAK Hauptschalter Strom an den Wechselrichter liefern kann. Optional können die Trennschalter auch manuell ein- bzw. ausgeschaltet werden. Mit Hilfe eines Status-Schalters 83 kann die aktuelle Schalterstellung der Trennschalter 11x, 11y ausgelesen werden. Die Zusatzeinrichtungen (Shunt trip, Recloser, Hilfsschalter mit dem der Schaltzustand des Trennschalters ausgelesen werden kann) für die Trennschalter 11x, 11y sind in Fig. 3 mit 11v bezeichnet.

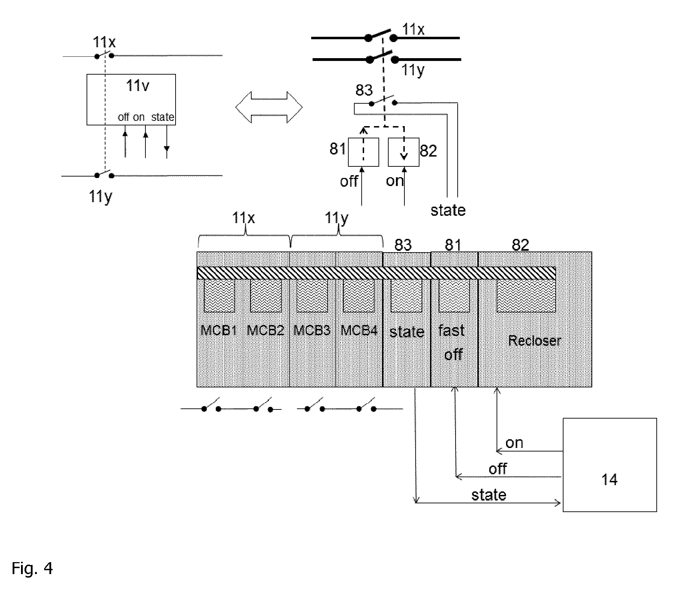

In Fig. 4 ist noch einmal ein möglicher Aufbau von 11v gezeigt. Oben links ist zu erkennen, dass für die Trennschalter 11x (Plus) und 11y (Minus) gemeinsam die Zusatzeinrichtungen einmal vorhanden sind. 11v besteht aus einen "Shunt Trip" 81, einem Wiedereinschaltgerät (82) und optional aus einem Schalter 83, der den Schaltzustand (Status, state) der Trennschalter abfragt. Die Trennschalter 11x und 11y sind so miteinander verbunden, dass entweder beide eingeschaltet sind oder beide ausgeschaltet sind. Im unteren Teil von Fig. 4 ist ein möglicher Aufbau mit Schaltelementen skizziert, die auf der Hutschiene montiert sind, und wie sie für Elektro-Verteilerkästen typisch sind. Hierbei erkannt man, dass 11x und 11y jeweils aus zwei seriell verschalteten MCB (miniatur circut breaker) aufgebaut sind (die Serienschaltung ist häufig wegen der hohen PV-Systemspannung erforderlich). Übliche MCBs verfügen häufig über eine thermischen und eine magnetischen Überlast-Abschalteinrichtung. Da in vorliegenden Fall die MCBs gesteuert von der Steuerelektronik über den "Shunt Trip" abgeschaltet werden, sind die im MCB eingebaute thermische Abschaltung und magnetische Abschaltung genau genommen redundant. Trotzdem bietet sich die Verwendung von MCBs an, da diese in großer Vielfalt und preiswert am Markt verfügbar sind.

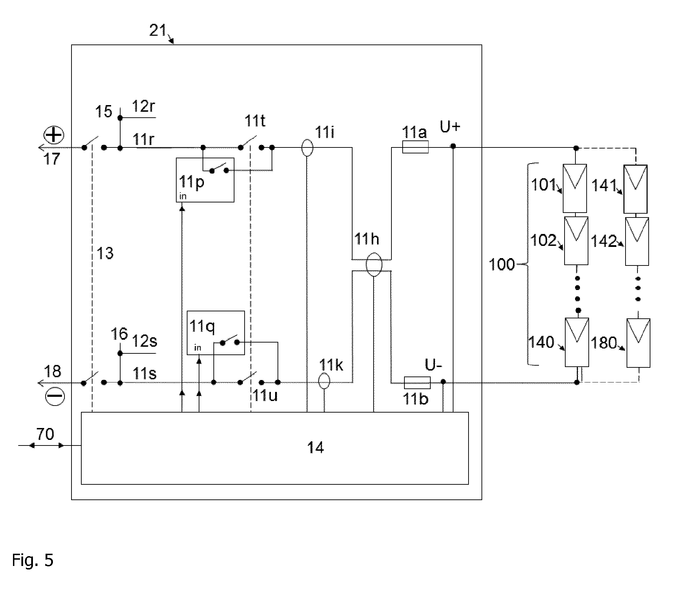

In Figur 5 ist ein Beispiel für den erfindungsgemäßen Generatoranschlusskasten mit der zweiten Alternative von Trennschaltern gezeigt. Im Unterschied zu Figur 2 wird auf die Diode verzichtet (wie auch schon in Bild 3) und es sind zusätzlich die Relais 11t, 11u und die dazugehörenden Bypass-schalter 11p, 11q, sowie zusätzlich 11h, ein Differenzstrommesssystem vorhanden, mit dessen Hilfe die Fehlerströme erkannt werden. Das Differenzstrommesssystem, wie auch die anderen Stromsensoren können beispielsweise mit Stromsensoren auf der Basis von Hallsensoren arbeiten, die das Magnetfeld der Leitungen messen. Es wurde gefunden, dass empfindliche Differenzstromsensoren dadurch aufgebaut werden können, dass die beiden Strom führenden Leiter mit einem koaxialen Doppelleiter durch die Messöffnung des Magnetfeldsensors geführt werden. Im Normalbetrieb sind die Relais 11t, 11u und die dazugehörenden Bypass-schalter 11p, 11q alle im eingeschalteten Zustand und es fließt ein hoher Strom (z. B. 20 A) über den Plus-Strompfad (gebildet aus Schmelz-Sicherung 11a, Differenzstromsensor 11h,Stromsensor 11c, Relais 11t, Bypass-schalter 11p und endend mit dem Anschluss 11r an der Plus-Sammelschiene 15) bzw. den Minus Strompfad (gebildet aus Sicherung 11b, Differenzstromsensor 11h, Stromsensor 11d, Relais 11u, Bypass-schalter 11q und endend mit dem Anschluss 11s an der Minus-Sammelschiene 16).

Sofern im Betrieb die mit 11h gemessene Stromdifferenz und damit der Fehlerstrom eine bestimmte Schwelle (z. B. 30 mA) überschreitet, wird dies von der Steuerelektronik 14 erkannt und als gefährlich eingestuft und die Relais 11t und 11u werden von der Steuerelektronik so angesteuert, dass die Schalter den Stromfluss unterbrechen. Damit fließt der Strom nach der Kontaktprellphase nicht mehr über die Relais 11t, 11u sondern nur noch über die Bypass-schalter 11p, 11q, die von der Steuerelektronik 14 an den jeweiligen Steuereingang (mit "in" bezeichnet) die notwendigen Signale erhalten um auch während der Kontaktprellphase eingeschaltet zu sein. Nach der Kontaktprellphase von beispielsweise 10 ms werden diese Schalter ebenfalls geöffnet und der Abtrennvorgang ist abgeschlossen. Da es sich hier um elektronische Schalter handelt, besteht keine Gefahr der Lichtbogenbildung oder es gibt auch keinen Verschleiß durch Abbrennen von mechanischen Schalt-Kontakten.

Sofern einmal ein gefährlicher Fehlerstrom erkannt wurde, und über die beschriebene Schaltsequenz die Modulgruppe abgetrennt ist, bleibt die entsprechende Modulgruppe abgeschaltet. Denkbar ist, dass dann automatische Diagnoseroutinen ablaufen bei denen z. B. der Isolationswiderstand der Modulgruppe gegenüber Erde, die Potentiale an den jetzt abgetrennten Plus und Minuspolen der Modulgruppe, oder Impedanzmessungen oder Kennlinienmessungen (Wie verhält sich die Spannung der Modulgruppe bei Belastung) an der Modulgruppe durchgeführt werden.

Die Modulgruppe kann dann ferngesteuert von einem übergeordneten Monitoring und Wartungssystem wieder eingeschaltet werden, wenn die Diagnoseroutinen ausgewertet sind und keine gefährlichen Auffälligkeiten mehr vorliegen.

Über die Stromsensoren 11i und 11k wird der Strom überwacht, den die Modulgruppe liefert, wobei einer der Stromsensoren in den meisten Fällen auch als redundant angesehen werden kann.

Wird erkannt, dass die betrachtete Modulgruppe keinen Strom liefert, sondern Strom zieht (Rückstrom) dann kann, wie oben beschrieben, die Modulgruppe abgetrennt werden. Optional können auch hier zusätzliche Diagnoseroutinen ablaufen. Der abgetrennte Zustand sollte mindestens so lange bestehen, bis die Lehrlaufspannung der abgetrennten Modulgruppe signifikant und relevant über die Spannung steigt, die von den anderen Modulgruppen an das Wechselrichtersystem geliefert wird. Bei Anwendung des beschriebenen Algorithmus kann man auf den Einbau von "Blocking Dioden" verzichten mit dem Vorteil, dass auch die damit verbundenen elektrischen Verluste wegfallen. Zusätzlich hat man damit - wie im Umfeld der Blocking Diode vorher beschrieben - die Möglichkeit mehr Strings im Feld parallel zu schalten und gemeinsam zum GAK zu leiten und damit zusätzliche Kosten zu sparen.

Wie in Figur 5 gezeigt, ist weiterhin unmittelbar am Hauptschalter die Plus Sammelschiene 15 angeschlossen, an der für jede Modulgruppe der entsprechende Plus Strompfad angeschlossen ist. Dieser Anschluss ist für die erste Modulgruppe mit 11r und für die zweite Modulgruppe 12r bezeichnet. Ebenso ist auch die Minus Sammelschiene 16 unmittelbar am Hauptschalter angeschlossen und auch daran sind für jede Modulgruppe die entsprechenden negativen Strompfade angeschlossen. Der entsprechende Anschluss für die erste Modulgruppe ist 11s und für die zweite Modulgruppe 12s.

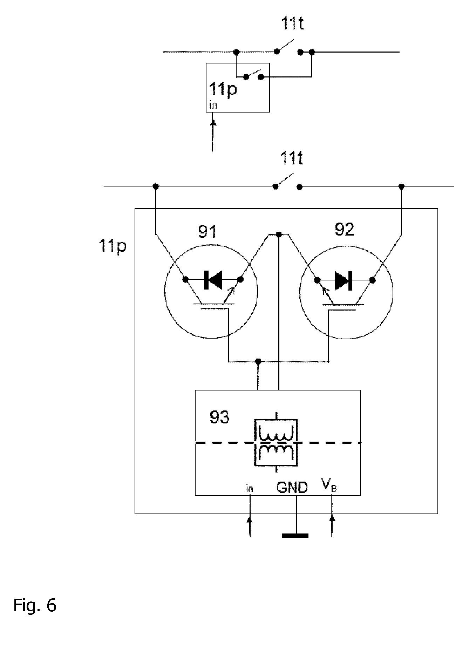

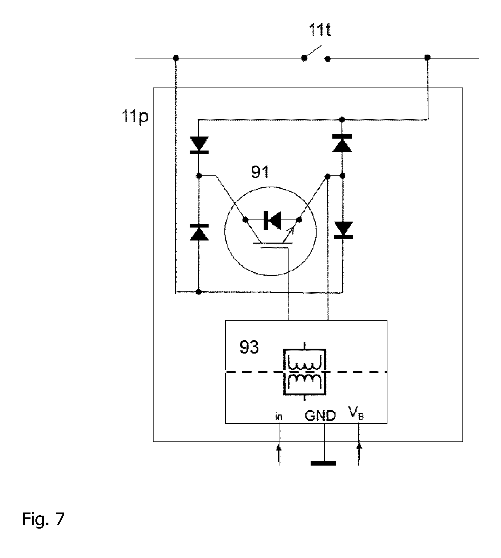

In Figur 6 ist im oberen Teil ein Ausschnitt aus Figur 3 mit dem Schalter 11t und dem Bypass-Schalter 11p gezeigt. Im unteren Teil der Figur, ist dann eine Realisierungsmöglichkeit für einen Bypass-Schalter am Beispiel des Schalters 11p, der dem Schalter 11t parallel geschaltet ist. Der Bypass-schalter wird von der Steuerelektronik 14 mit geringen Spanungspegeln gesteuert und muss zumindest kurze Zeit sehr hohe Ströme aufnehmen und schalten, die auf einem mehrere 100 V (typischerweise bis zu 1000 V) gegenüber der Steuerelektronik abweichenden Spannungsniveau liegen. Aus diesem Grund ist für das Steuersignal eine Potentialtrennung 93 erforderlich. Diese Potentialtrennung kann beispielweise kostengünstig realisiert werden mit Hilfe von iCoppler Schaltkreisen von Analog Devices. In Figur 6 und Figur 7 ist bei der Potentialtrennung auch die dafür notwendige Stromversorgung V_{B} und GND sowie der mit "in" bezeichnete Steuereingang eingezeichnet.

Wenn vom Bypass-Schalter auch Rückströme geschaltet werden sollen, dann muss der Schalter bidirektional arbeiten, was durch serielle Verschaltung zweier IGBT 91, 92 in unterschiedlicher Richtung erreicht werden kann, wobei die beiden Emitter verbunden sind. Die Ansteuerung der IGBTs erfolgt zwischen den beiden miteinander verbundenen Gates und den miteinander verbundenen Emittern. Den IGBTs ist jeweils noch eine Diode parallel geschaltet (Anode am Emitter, Kathode am Kollektor), wobei bei vielen handelsüblichen IGBTs diese Diode schon serienmäßig eingebaut ist. Alternativ zu den zwei seriell verschalteten IGBTs kann auch, wie in Figur 7 skizziert, ein IGBT 91 in Kombination mit einem Brückengleichrichter verwendet werden. Sollte - beispielsweise da an anderer Stelle eine Blocking-Diode vorgesehen ist - ein Schalten von Rückströmen nicht notwendig sein, genügt ein IGBT der so geschaltet ist, dass der elektrische Stromfluss vom Kollektor zum Emitter geht.

Unter Umständen kann es vorkommen, dass beispielsweise infolge von sehr großen Leitungslängen im Stromkreis der Module sehr große Induktivitäten vorhanden sind. In diesem Fall ist es sehr schwer, dass der Bypass Schalter schnell abschaltet, bzw. es müssen bei den Schaltvorgängen des Bypass-schalters deutlich größere Energiemengen als vorher abgeschätzt in Wärme umgewandelt werden.

In diesen Fällen ist es wünschenswert, wenn man ein Schalternetzwerk hat, bei dem während der Schaltvorgänge auch größere Energiemengen umgesetzt werden können.

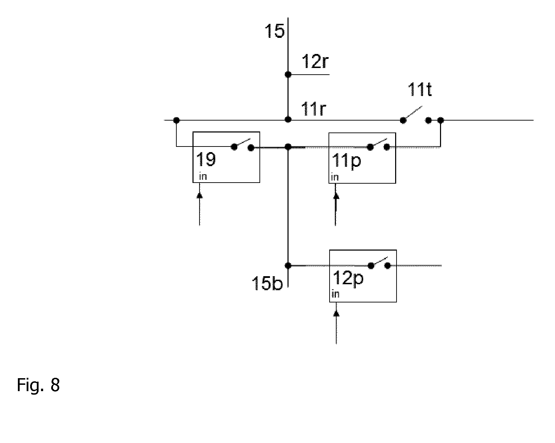

Für diesen Fall ist eine Figur 8 eine modifizierte Schaltung gezeigt.

Der bisher schon verwendete Bypass-schalter bekommt jetzt eine etwas andere Funktion. Im Normalbetrieb ist der Relais eingeschaltet und der Bypass-Schalter ausgeschaltet. Wenn eine Modulgruppe abgetrennt werden soll, schaltet der Bypass-schalter 11p dem Relais 11t (bzw. 11u) den neu eingeführten Transienten-Schalter 19+ (bzw. 19-) parallel. Für ein System mit mehreren Modulgruppen wird dabei nur jeweils ein Transienten-Schalter für den Plus-Strompfad und einer für den Minus-Strompfad benötigt. Aus diesem Grund ist es auch ohne große Zusatzkosten möglich, die Transientenschalter von der Leistung größer zu dimensionieren, so dass sie in der Lage sind auch größere Energiemengen zerstörungsfrei zu verarbeiten.

Die Funktion wird am Beispiel des Plus-Strompfades der ersten Modulgruppe veranschaulicht. Parallel zum Relais 11t liegt während des kritischen Umschaltvorgangs eine Serienschaltung des Bypass-schalters 11p sowie des Transientenschalters 19+.

Zustand vor Ausschalten:
Relais 11t ist eingeschaltet; Bypass-Schalter 11p ist ausgeschaltet;
Transientenschalter 19+ ist eingeschaltet (dies ist der Bereitschaftszustand).

Schaltsequenz beim Ausschalten:
- Bypassschalter wird eingeschaltet (sehr schnell im Bereich von µs)
- Relais wird abgeschaltet (Kontaktprellphase folgt z. B. 10 ms)
- Nach Abschluss der Kontaktprellphase wird Transientenschalter 19+ abgeschaltet wobei hier während der Abschaltphase die größte Schaltenergie umgesetzt wird.
- Nachdem der Transientenschalter 19+ vollkommen ausgeschaltet ist, wird der Bypass-Schalter wieder abgeschaltet und daraufhin der Transientenschalter wieder eingeschaltet, so dass der Transientenschalter im Bereitschaftszustand ist.

Schaltsequenz beim Einschalten:
- Transienten-schalter 19+ wird abgeschaltet
- Bypassschalter wird eingeschaltet (sehr schnell im Bereich von µs)
- Transienten-schalter 19+ wird eingeschaltet wobei hier während der Einschaltphase die größte Schaltenergie umgesetzt wird.
- Relais wird eingeschaltet
- Bypass-schalter wird abgeschaltet

Da die beiden Transientenschalter (für Plus und Minus) nur immer für eine Modulgruppe (Kanal des GAK) zur Verfügung stehen, können zwei Modulgruppen nicht gleichzeitig eingeschaltet bzw. ausgeschaltet werden. Da die Umschaltvorgänge aber nur wenige ms benötigen dürfte dies in der Praxis keine Rolle spielen, da nicht zu erwarten ist, dass in verschiedenen Modulgruppen gleichzeitig (innerhalb weniger ms) ein Fehler auftritt, der einen Schaltvorgang erforderlich macht!

In Figur 9 ist zu erkennen, dass dem Relais 11t die Serienschaltung von Bypass-Schalter 11p und Transientenschalter 19 parallel geschaltet ist, wobei der Transientenschalter 19 sowie der Relais 11t direkt an der Sammelschiene für Plus 15 angeschlossen ist. Zwischen Transientenschalter 19 und Bypass-Schalter ist noch ein Abgriff zur Bypass Sammelschiene 15b vorgesehen, an dem die Bypass-Schalter 12p für die zweite Modulgruppe sowie nicht gezeichneten Bypass-Schalter für weitere Modulgruppen (GAK-Kanäle) angeschlossen werden können. Für einen Fachmann ist klar, dass eine vergleichbare Schaltung wie hier für den Plus-Strompfad beschrieben auch für den Minus-Strompfad existieren muss.

Als ein Fehlerzustand könnte es vorkommen, dass ein für eine Modulgruppe vorgesehener Eingangskanal des GAK kurzgeschlossen ist.

Um diesen Fehlerfall, der bevorzugt bei der Installation der Anlage auftreten kann zu vermeiden ist es außerdem ratsam, dass bevor ein Kanal des GAK eingeschaltet wird (d. h. in der Regel bevor eine Modulgruppe eingeschaltet wird, über eine Diagnoseroutine überprüft wird ob nicht ein Kurzschluss, eine Verpolung der Modulgruppe, oder ein anderes unerwartetes Fehlerbild vorliegt.

Der Aufbau der Transientenschalters kann sehr ähnlich dem des Bypass-schalters sein, mit dem wesentlichen Unterschied, dass der Transientenschalter auch größere Schaltenergien zerstörungsfrei verarbeiten kann.

## Patentansprüche

1. Sicherheitssystem für große PV-Kraftwerke, **dadurch gekennzeichnet dass** der DC-Teil des PV-Kraftwerks in kleinere Modulgruppen eingeteilt wird, innerhalb derer gefährliche Fehlerströme detektiert werden und sofern die Fehlerströme einen bestimmten Schwellwert überschreiten die betreffende Modulgruppe vom Gesamtsystem abgetrennt wird mit Hilfe eines Sicherheits-Trennschalters, der ein schnelles Abschalten einschließlich des Verlöschens des dabei entstehenden Lichtbogens gewährleistet.

2. Sicherheitssystem für große PV-Kraftwerke nach Anspruch 1, **dadurch gekennzeichnet, dass**
der Sicherheits-Trennschalter ergänzt wird mit einem Shunt Trip, der ein schnelles Abschalten des Sicherheits-Trennschalters ermöglicht, sowie durch ein Wiedereinschaltgerät, so dass der Sicherheits-Trennschalter durch eine Steuerelektronik ein und ausgeschaltet werden kann.

3. Sicherheitssystem für große PV-Kraftwerke nach Anspruch 1, **dadurch gekennzeichnet, dass**
der Sicherheits-Trennschalter durch einen Relais realisiert wird, dem ein elektronisches Schalternetzwerk parallel geschaltet ist, das verhindert, dass es zu einem dauerhaften Lichtbogen im Relais kommt, wobei das Schalternetzwerk mindestens aus einem Bypass-Schalter besteht.

4. Sicherheitssystem für große PV-Kraftwerke nach Anspruch 1, 2 oder 3,
**dadurch gekennzeichnet, dass**
beim Abtrennen einer Modulgruppe sowohl der Plus-Strompfad als auch der Minus-Strompfad abgetrennt werden.

5. Sicherheitssystem für große PV-Kraftwerke nach Anspruch 3, **dadurch gekennzeichnet, dass**
das elektronische Schalternetzwerk durch einen Bypass-Schalter gebildet wird, der während der Kontaktprellphase des mechanischen Schalters eingeschaltet ist.

6. Sicherheitssystem für große PV-Kraftwerke nach Anspruch 5, **dadurch gekennzeichnet, dass**
das elektronische Schalternetzwerk gebildet wird aus der Serienschaltung eines Bypass- und eines Transientenschalter, und dass während der Kontaktprellphase des Relais sowohl der Bypass-schalter als auch der Transientenschalter eingeschaltet sind.

7. Sicherheitssystem für große PV-Kraftwerke nach Anspruch 6, **dadurch gekennzeichnet, dass**
bei einem Einschaltvorgang der Transientenschalter bei eingeschaltetem Bypass-schalter vor dem Relais einschaltet.

8. Sicherheitssystem für große PV-Kraftwerke nach Anspruch 6 oder 7, **dadurch gekennzeichnet, dass**
bei einem Ausschaltvorgang der Transientenschalter bei eingeschaltetem Bypass-schalter nach dem Relais ausschaltet.

9. Sicherheitssystem für große PV-Kraftwerken nach Anspruch 6, 7 oder 8,
**dadurch gekennzeichnet, dass**
in einem Generatoranschlusskasten für mehrere Modulgruppen ein gemeinsamer Transientenschalter verwendet wird.

10. Generatoranschlusskasten für mehrere Modulgruppen, **dadurch gekennzeichnet, dass**
mindestens ein Sicherheitssystem nach Anspruch 1, 2,3,4,5,6,7, 8 oder 9 zur Anwendung kommt.

11. Generatoranschlusskasten für mehrere Modulgruppen nach Anspruch 10
**dadurch gekennzeichnet, dass**
der Generatoranschlusskasten zusätzlich Diagnoseroutinen durchführen kann bei denen der Isolationswiderstand einer Modulgruppe gegenüber Erde überprüft wird.

12. Generatoranschlusskasten für mehrere Modulgruppen nach Anspruch 10, oder 11 **dadurch gekennzeichnet, dass**
der Generatoranschlusskasten zusätzlich Diagnoseroutinen durchführen kann bei denen die Impedanz einer Modulgruppe ermittelt wird.

13. Generatoranschlusskasten für mehrere Modulgruppen nach Anspruch 10, 11
oder 12 **dadurch gekennzeichnet, dass**
der Generatoranschlusskasten zusätzlich Diagnoseroutinen durchführen kann bei denen die Leerlaufspannung einer Modulgruppe ermittelt wird.

14. Generatoranschlusskasten für mehrere Modulgruppen nach Anspruch 10, 11, 12 oder 13 **dadurch gekennzeichnet, dass**
der Generatoranschlusskasten zusätzlich Diagnoseroutinen durchführen kann bei denen der Kurzschlussstrom einer Modulgruppe ermittelt wird.

15. Generatoranschlusskasten für mehrere Modulgruppen nach Anspruch 10, 11, 12, 13 oder 14 **dadurch gekennzeichnet, dass**
der Generatoranschlusskasten zusätzlich Diagnoseroutinen durchführen kann bei denen die Kennlinie einer Modulgruppe ermittelt wird.

16. Generatoranschlusskasten für mehrere Modulgruppen nach Anspruch 10, 11, 12, 13, 14 oder 15 **dadurch gekennzeichnet, dass**
die Ergebnisse der Diagnoseroutinen rund um die Uhr ausgewertet werden so dass das Fehlen eines Modus ermittelt werden kann.

17. Generatoranschlusskasten für mehrere Modulgruppen nach Anspruch 10, 11, 12, 13, 14, 15 oder 16 **dadurch gekennzeichnet, dass** ein oder mehrere Maximum Power Point Tracker für jeweils eine oder mehrere Modulgruppen eingebaut sind.

18. Generatoranschlusskasten für mehrere Modulgruppen nach Anspruch 10, 11, 12, 13, 14, 15, 16 oder 17 **dadurch gekennzeichnet, dass** nachts ein definierte Spannung an die Module angelegt wird, wodurch Schäden durch PID ganz oder teilweise wieder ausgeheilt werden.

19. Generatoranschlusskasten für mehrere Modulgruppen nach Anspruch 10, 11, 12, 13, 14, 15, 16, 17 oder 18 **dadurch gekennzeichnet, dass** für die Energieversorgung der Systeme des Generatorschlusskastens ein DC-DC-Wandler mit sehr weitem Eingangsspannungsbereich vorgesehen ist, dessen Eingangsspannungsbereich unter 100 V beginnt und bis zur Systemspannung des PV Systems gehen sollte.
